# EUROPEAN PATENT SPECIFICATION

(11) **EP 0 858 111 B1**
(45) Date of publication and mention of the grant of the patent: **07.07.2010**
(21) Application number: 98870025.8
(22) Date of filing: 06.02.1998
(51) Int. Cl.: H01L 27/146

(54) **A detector for electromagnetic radiation, pixel structure with high sensitivity using such detector and method of manufacturing such detector**
Detektor für elektromagnetische Strahlung, diesen verwendende Pixelstruktur mit hoher Empfindlichkeit und Verfahren zu seiner Herstellung
Détecteur de radiations électromagnétiques, structure d'un pixel à haute sensibilité utilisant ce détecteur et procédé de fabrication

(30) Priority: 10.02.1997 US 37531 P; 04.06.1997 EP 97870084
(43) Date of publication of application: 12.08.1998
(73) Proprietor: Cypress Semiconductor Corporation (Belgium) BVBA, 2800 Mechelen (BE)
(72) Inventor: Dierickx, Bart, 2640 Mortsel (BE)
(74) Representative: Cooper, John

(56) References cited:
- EP-A- 0 739 039
- WO-A-93/19489
- US-A- 5 614 744
- DIERICKX B: "XYW detector: a smart two-dimensional particle sensor" INTERNATIONAL WORKSHOP ON SILICON PIXEL DETECTORS FOR PARTICLES AND X-RAYS, LEUVEN, BELGIUM, 31 MAY-2 JUNE 1988, vol. A275, no. 3, ISSN 0168-9002, NUCLEAR INSTRUMENTS & METHODS IN PHYSICS RESEARCH, SECTION A (ACCELERATORS, SPECTROMETERS, DETECTORS AND ASSOCIATED EQUIPMENT), 1 MARCH 1989, NETHERLANDS, pages 542-544, XP002046388
- KLEIN P ET AL: "Design and performance of semiconductor detectors with integrated amplification and charge storage capability" SECOND INTERNATIONAL WORKSHOP ON SILICON PIXEL DETECTORS FOR PARTICLES AND X-RAYS, LEUVEN, BELGIUM, 19-21 JUNE 1990, vol. A305, no. 3, ISSN 0168-9002, NUCLEAR INSTRUMENTS & METHODS IN PHYSICS RESEARCH, SECTION A (ACCELERATORS, SPECTROMETERS, DETECTORS AND ASSOCIATED EQUIPMENT), 1 AUG. 1991, NETHERLANDS, pages 517-526, XP000240469

## Description

### Field of the invention

The present invention relates to the field of semiconductor based detectors for electromagnetic radiation.

More in particular a semiconductor detector and a semiconductor pixel structure for detecting electromagnetic radiation with a large radiation sensitive area or a high fill factor are disclosed.

The present invention also relates to a method of manufacturing such detector.

### Background of the invention

Semiconductor based sensors and devices for detecting electromagnetic radiation are known in the art. Examples of such sensors are disclosed in EP-A-739039 and in WO93/19489. These sensors are implemented in a semiconductor substrate in CMOS- or MOS-technology. In these sensors, the regions adapted for collecting charge carriers being generated by the radiation in the semiconductor substrate are forming a p-n or a n-p junction with the substrate that is of a n type conductivity or p type conductivity respectively. Such junctions are called collection junctions. Among the image sensors implemented in CMOS- or MOS-technology, CMOS or MOS image sensors with passive pixels and CMOS or MOS image sensors with active pixels are distinguished. The sensors of EP-A-739039 and WO93/19489 are active pixel sensors.

An active pixel is configured with means integrated in the pixel to amplify the charge that is collected on the light sensitive element or component in the pixel. Passive pixels do not have said means and require a charge-sensitive amplifier that is not integrated in the pixel and is connected with a long line towards the pixel. Due to the additional electronics in the active pixel, an active pixel image sensor may be equipped to execute more elaborated functions, which can be advantageous for the performance of the imaging device or system based on the sensor. Said functions can include filtering, operation at higher speed or operation in more extreme illumination conditions. It remains however a main drawback of active pixel CMOS or MOS image sensors, and to a lesser extent also of passive pixel sensors, that a significant part of the surface of the pixel is used for readout circuitry.

It is known that the charge sensitive volume of a p-n or n-p junction is larger than the depletion layer of the junction. In fact all charges generated within a so called recombination length from the collection junction have a chance of diffusing to that junction and of being collected. Based on this mechanism it is possible to make a sensor with a small junction and yet a large photosensitive volume. Photosensors can be made with junctions of 3 by 2 micrometers and with a recombination length of 15 µm. Thus such detector has an apparent front size or photosensitive region of 30 µm diameter. However if a non-related electronic circuitry such as readout circuitry is placed in the neighbourhood of such collection junction, part of the charges that otherwise would have reached the collection junction will be collected by junctions or components of the readout circuitry. The charge carriers generated by light falling on the regions of the detector that are used for readout circuitry therefore are mainly collected by the junctions of this readout circuitry. The area taken by the readout circuitry in the pixels therefore is lost for collecting the radiation and this is essentially the reason for the low fill factor or low sensitivity of active pixel based sensors.

The book "Solid-State Imaging with Charge Coupled Devices", of A. Theuwissen (Kluwer Academic publishers, 1995 ISBN 0-7923-3456-6) gives an overview of the present state of the art of semiconductor based imaging devices, such as CCDs and MOS camera's. Chapter 7 of this book is devoted to the topic of increasing the sensitivity or the effective fill factor of a pixel. It covers such methods as the use of micro lenses or the use of a photo conversion top layer.

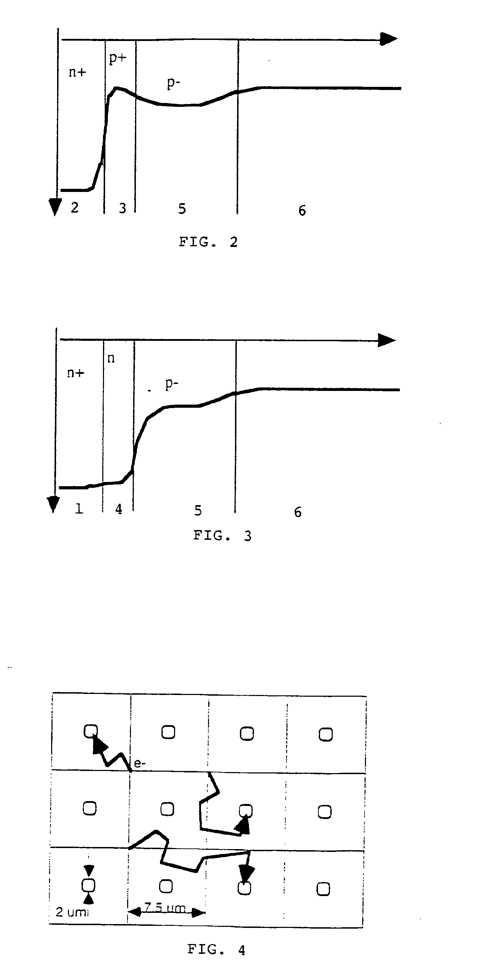

In the article "XYW detector a smart two-dimensional particle detector", by Bart Dierickx, published in Nuclear Instruments and Methods in Physics Research, vol. A275 (1989), p.542-544, fig. 4 shows 4 methods to fabricate semiconductor based pixel devices. The first method is based on classic CMOS processing. The disadvantage of this method is quoted to be a low fill factor, since part of the semiconductor surface is occupied by readout electronic circuitry. The other methods attempt to solve the fill factor problem by using non-standard-CMOS techniques : flip-chip (bump bonding), SOI (silicon-on-insulator) technology, or moving the photon-sensitive zone to an amorphous top-layer.

In the article "Design and Performance of semiconductor detectors with integrated amplification and charge storage capability", by P. Klein & al, published in Nuclear Instruments and Methods in Physics Research, vol. A305 (1991) pp. 517-526, figure 2 shows a semiconductor based sensor with a transistor junction wherein the charges being generated in the semiconductor substrate are prevented from diffusing into the source and drain junctions of the transistor by a junction-based barrier and are constrained to the gate, the gate being in contact with the source and drain.

Avalanche photo diodes (ADPs) are also known in the art. An APD can consist of a structure having layers in a sequence p⁺⁺/p⁻/p⁺/n⁺⁺, where the p++ layer is the backside contact, the p- layer is a detection layer, the p+ layer is serving for avalanche multiplication of electrons, and the n++ layer is finally the collection layer of the multiplicated electrons. The dopant level and width of the multiplication layer is very critical. Furthermore the applied voltage over such a structure is rather high, close to the electric breakdown of the structure. The p-/p+ layer transition is not acting as a barrier for the diffusion of electrons, but as an avalanche multiplication device.

### Aim of the invention

It is an aim of the present invention to disclose a semiconductor based device for detecting electromagnetic radiation wherein substantially all of the charge carriers being generated by said radiation in the semiconductor are collected into the collection junctions and regions, instead of into regions and junctions of the readout circuitry.

### Summary of the invention

The present invention relates first to a detector for electromagnetic radiation according to claim 1 and its manufacturing method according to claim 12.

### Brief description of the drawings

Figures 1a and 1b schematically show a detector of the invention and a detector not forming part of the invention respectively.

Figure 2 represents the electrostatic potential in the detector as shown in figure 1a according to the cross sections along line I.

Figure 3 represents the electrostatic potential in the detector as shown in figure 1a according to the cross sections along line II.

Figure 4 shows a simulation of the diffusion of charge carriers in the structure as schematically shown in figure 1a according to Monte-Carlo-simulations.

Figure 5a and 5b show results measured on sensors being manufactured according to the present invention (5b) and on sensors being manufactured according to the prior art (5a).

Figure 6 shows a pixel structure according to the invention which has a memory element in the pixel.

Figure 7 shows a cross section in the semiconductor substrate of a possible implementation of the pixel structure of figure 6.

Figure 8 shows the detector of the invention applied in a first low dark current pixel.

Figure 9 shows detector structure not forming part of the invention applied in a second low dark current pixel .

Figure 10 shows two cross sections of surface channel CCD-like structures.

### Detailed description of the invention

The present invention discloses a semiconductor based detector for radiation with a small but effective barrier between the radiation sensitive volume in the semiconductor substrate and the regions and junctions with readout circuitry, and with no or a lower barrier between the radiation sensitive volume in the semiconductor and the regions and junctions adapted and meant for collecting the charge carriers being generated by the radiation. The region forming the barrier inbetween the radiation sensitive volume wherein charges are created and the unrelated electronics of the readout circuitry, can have dopants of the same conductivity type as the radiation sensitive volume.

The detector of the present invention can comprise a collection junction, which collects radiation generated charge carriers, and other electronic components. Said collection junction has an enhanced collection for charge carriers that are generated in the radiation sensitive volume underneath said other electronic components. Such functionality is made by means of an electrostatic barrier, that is formed at the interface of the volume and a region with the same conductivity type as said volume underneath said other electronic components. The barrier prevents the charge carriers which are generated underneath said other electronic components from diffusing into the junctions or structures of said other electronic components. This electrostatic barrier is not, or with a substantially lower height, present underneath the collection junction, which can consequently gather the charge carriers that are generated under the other electronics components.

This detector can be realised in a CMOS process, wherein the components are realised in a p type substrate, the region forming the electrostatic barrier is realised as a p+ type implant, and the other components are of various type, including n type junctions. The collection junction is formed by a n type region with a low electrostatic barrier to the substrate. The area of lower (or absent) barrier may coincide with the collection junction, overlap it completely or partly, or be a part of it. The lower (or absence of) barrier can be realised by an additional n type implant in the area of the collection junction, or by the absence of the p+ type implant which realises said electrostatic barrier.

Said p+ type implant can be a so-called pwell implant, or a so called anti-punch through implant, or a so-called blanket implant, or a so-called Vₜₕ-adjust implant, which have all about the same effect in a CMOS process, and which are in many cases available as a standard step in a CMOS process.

Said n type implant can be an implant such as a so-called nwell implant, or a so called anti-punch through implant, or a so-called blanket implant, or a so-called Vₜₕ-adjust implant.

In an alternative embodiment of the invention, the detector forms part of a pixel structure wherein the collection junction (with the deeper n type implant) is realised as one electrode (source or drain) of a MOSFET, and the other electrode is tied to a certain voltage. The precise voltage is not relevant : the only condition is that the other electrode should not be a floating node. The collection junction should be completely (preferred) or partially surrounded by the gate of said MOSFET; the other electrode then surrounds (wholly or partially) the gate and first electrode. The gate of the MOSFET is biased "off", so that both electrodes are electrically isolated. The fact that the MOSFET gate and other electrode surround the junction will reduce the part of the dark current that is due to junction edge effects.

The principle of the invention can be applied to a CCD or CCD-like structure (photo gate, charge injection device (CID), charge sweep device(CSD)) where the collecting junction is an inversion layer or buried channel beneath a CCD-electrode (thus a surface channel CCD or a buried channel CCD. The collection junction (or part thereof) can be thought to be replaced by such structure.

In a way of explaining the invention, the invention is described in the sequel by means of the example of a CMOS based light sensitive sensor with a pixel structure such as disclosed in EP-A-0739039. The teaching of EP-A-0739039 is incorporated herein by reference. In the example being described in the sequel, it is assumed that the semiconductor substrate is of a p type conductivity. It is obvious that the person skilled in the art will imagine equivalent structures to those described in the sequel that have a semiconductor substrate of a n type conductivity.

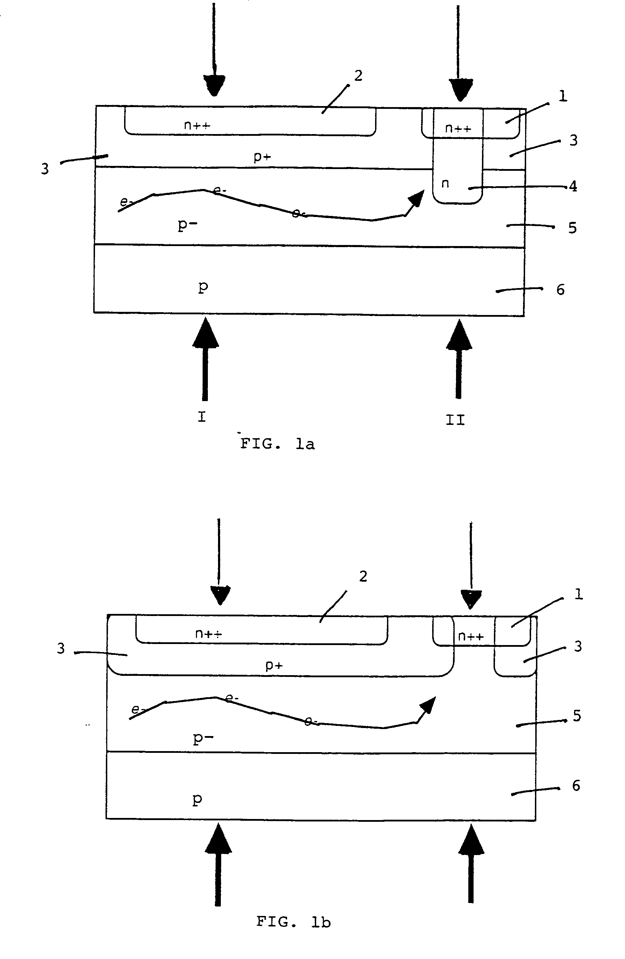

Figure 1a schematically shows part of a pixel structure with the semiconductor substrate (6) having a p type doping. A p- layer or region (5) is defined in said substrate. The substrate can be of a uniform p- or p++ doping either in alternate embodiments. The p- layer can be defined by diffusion or by ion implantation or epitaxial growth or other techniques known in CMOS based processing. An additional p+ layer or region (3) is defined on or in said p- layer/substrate. The p+ region can be defined by diffusion or by ion implantation or epitaxial growth or other techniques known in CMOS based processing. In the p+ region (3) a first region (1) and a second region (2) are defined. These first and second regions are of a n type doping. These first and second regions can be defined by ion implantation or diffusion or other techniques known in CMOS based processing. These first and second regions form a junction with the p type based regions and/or substrate. The first region (1) is to be a collection junction for collecting the charge carriers being generated by radiation in the substrate and/or p- region (6, 5). According to the example the collection junction is a photodiode. The second region (2) is to form a junction being part of readout circuitry for processing the signals being generated by the charge carriers being collected by said first region (1) . An additional, optional n type fourth region (4) can be defined and can overlap completely or partially said first region (1). This fourth region extends from said first region to said p- layer and/or to said substrate. This fourth region by preference is defined by a deep ion implantation step but may also be defined by other techniques known in CMOS based processing.

Figure 1b shows an example of a device not forming part of the invention shown in figure 1a.

Figures 2 and 3 show the electrostatic potential in the structure as shown in figure 1 according to cross-sections following lines I and II respectively. In the structure shown in figure 1 there is a local potential minimum in the p- region, as indicated in figures 2 and 3. As shown in figure 2, electrons in the p- region(s) will not diffuse easily to the second region (2), as there is an electrostatic barrier at the interface (3/5) created by the p+ region (3). According to figure 3, electrons will not be impeded by a barrier between the p-region (5) and the n+ region(1). It is clear that electrons in zone "I" will diffuse sidewards to the zone "II", and be collected in the first region (1).

The diffusion of charge carriers in the structure as schematically shown in figure 1 was simulated according to Monte-Carlo-simulations. Such simulation is represented in figure 4. The "random walk" of electrons that are generated by radiation in a matrix of pixels according to the present invention was simulated. The pixels were manufactured according to the structure shown in figure 1a. The average diffusion distance of the electrons was recorded. In a structure wherein the fourth region (4) is not present (thus, a prior art structure), the diffusion distance is large and the electrons diffuse over several pixel distances before being collected or being recombined with a hole. In a structure having the fourth region (4) , the electrons are collected much faster, as shown in the table below. A pixel matrix with pixels on a pitch of 7.5 x 7.5 micrometer was simulated, and in each pixel first and fourth regions of various size were present. Electrons are in a worst case scenario generated at the edge point between 4 pixels.

| **size of collecting junction (1,4)** | **diffusion distance in x (σₓ)** |
|---|---|
| region (4) absent | 15.5 µm |
| 1 µm | 6.1 µm |
| 2 µm | 4.5 µm |

The resulting diffusion distances come close to the ideal result (3.75 µm). This kind of pixels have thus a near-ideal Modulation Transfer Function (MTF). It has also a near 100% fill factor, which means that all surface of the pixel matrix that is exposed to light contributes to the light collection. Substantially, all of the substrate charge carriers generated by the light will flow to the collection junction. In prior art pixel structures, parts of the generated charge carriers are collected by the junctions of readout circuitry, and such charge is thus lost.

The introduction of the region (3) has several effects, two of these are :
- the photo diodes (1,4-5,6) collect photo charge from the whole pixel and may reach a 100% fill factor. The photo diodes collect photo charge from the whole pixel, the fill factor only being limited by mainly 3 factors:
   - light trapped inside the junctions of the readout circuitry themselves. This is certainly a limitation for short wavelength light, which has a low penetration depth ;
   - light reflected by the interconnect metallisation ;
   - recombination ; free electrons will not diffuse indefinitely, but recombine after some typical recombination length; in a CMOS technology, this length turns out to be several times the pixel pitch.
- the sharpness or MTF of the image. As a region (3) is present between the substrate and the collection junctions (1), region (3) forming a barrier for the diffusion of charge carriers at the region(3)/substrate interface, this will prevent an easy collection of charge carriers by the collection junction (1). The free carriers will have time to diffuse to neighbouring pixels and are eventually collected or recombined there, and cause thus an unsharp image. The omission of such barrier by the definition of region (4) in the photo diode tends to confine the photo charge.

### Preferred embodiment of the invention

In a standard CMOS process two (a,b) small arrays of photo diodes were fabricated as part of an integrated circuit. In case (a), the junctions are like prior art shallow n type regions in a p type substrate. The junctions measure 2x2 µm, the pixel pitch is 7.5 µm. A central row of the pixel array is exposed to light, neighbouring rows of pixels are covered from the light by a metal shield. The parallel outputs of rows of pixels are taken outside the integrated circuit, so that the effective photo current of a row of pixels can be measured. In case (b), the structure is identical, except that in every photo diode, a small 2 x 2 um nwell implant is made inside the photo diode. It must be noted that the CMOS process used here features a so-called pwell, which is a complementary implant to the nwell. Any area not exposed to the nwell implant is implanted with a p type dopant, to enhance the p type concentration close to the surface. The resulting structure is the preferred embodiment of the detector according to the schematic drawing of the invention in figure 1a. In the ideal case, the exposed row of pixels should detect all photo current, and the covered rows should deliver zero current. The fact that this is not the case is mainly due to sidewards diffusion of charges and to optical diffraction.

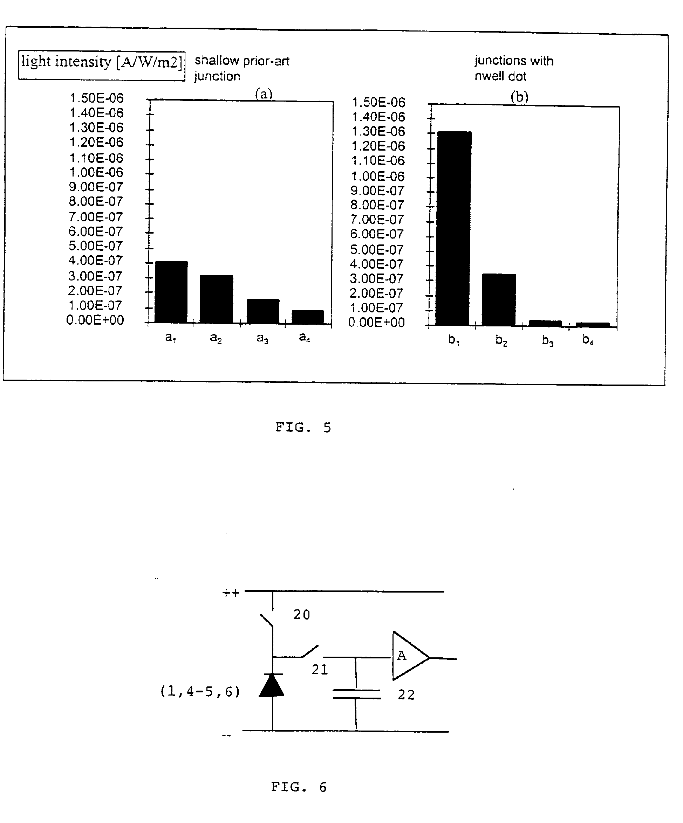

Measurements are summarised in figure 5, for both cases (a : prior art) and (b : with regions and junctions according to the invention). In the results shown in figure 5, "a1/b1" is the current collected by the exposed pixels, "a2/b2" by the (covered) neighbour pixel , "a3/b3" by the neighbour pixel thereafter, and "a4/b4" is the sum of the current collected by 4 successive neighbour pixels thereafter. The change of behaviour by the effect of the nwell dots as shown in figure 5 (b) proves the principle of the invention. Not only does the central exposed pixel row collect relatively more photo current (b1), but also the absolute level of the total current is much higher, which indicated that structure (b) collects current which is otherwise lost by recombination of charge carriers in structure (a).

Other realisations on various types of active pixels showed an even more prominent difference. As preferred embodiment, we used the 3 transistor pixel structure as disclosed in EP-A-0739039. Adding a small dot of nwell inside the photo diode increased the collected current dramatically, with a factor 5 to 10, for light of 650 nm. Considering the fact that the pixels were designed with a 15 % fill factor (area of the exposed photo diode only), then this factor of 5 to 10 indicates that the fill factor is to be close to 100%.

Advantages of the detector of the invention further include :
- photo charge being generated by light falling on areas of the pixel that are not covered by photo diode junctions are collected by the photo diode junctions, even if this area is covered by readout circuitry including junctions that can collect photo-generated charges too. The pixels of the invention have a near complete (100%) fill factor, except for those parts that are covered by opaque material as metal interconnections. The charge that is generated inside junctions of unrelated circuitry of course is lost for detection. As these junctions are shallow, radiation of wavelengths beyond about 500-600 nm is converted to electron-hole pairs deep in the silicon substrate, and this effect causes only a minor lowering of the sensitivity.
- The capacitance of the collection junction of the detector of the invention is considerably smaller than the capacitance of a junction that would cover the full pixel surface, yet they have effectively the same light collecting surface. One of the main noise sources in imaging sensors is the so-called kTC-noise . This noise is typically expressed as an amount of noise charge (uncertainty of the measurements of the photo charge), and is proportional to the square root of the capacitance of the junction. In order to obtain a pixel with a low noise charge, one must design low capacitance photo diodes. Yet, for a given capacitance per unit area, the lowest noise diode has also the smallest area, and thus a low light collecting area. The present invention allows to make photo diodes which have a small junction area and small junction capacitance, but with a large collecting volume.
- The devices of the preferred embodiment of the invention can be implemented in a custom CMOS technology with the possibility of performing implantations that are being adjusted so that the required profiles are present. The structure of the invention can be obtained even in standard CMOS technology. There are foundries which have a feature in their CMOS process called "twin well". Other foundries have similar structures but call them differently: Antipunch-through implant, blanket implants, Vₜₕ-adjust implant etc. The principle is the same, and can be used in the same way for realising the preferred embodiment of the present invention. In a twin well CMOS process, both nMOS and pMOS structures are fabricated in their own well (respectively pwell and nwell). In the sequel it is assumed that the silicon substrate is (relatively) lowly doped p type, or a lowly doped p type epitaxial layer on top of a highly doped wafer. pMOS structures are processed in a nwell, which is a deep junction in the substrate. nMOS structures are processed in a pwell, which in this case is not a junction (as it is of the same type as the substrate, being in this example a p type substrate, but nevertheless the result is that the nMOS structures are processed in a part which is higher doped than the substrate beneath. This and similar structures have been introduced in order to allow shorter channel transistors in a standard CMOS process. The present invention can be realised by using a n-junction as the light collecting junction, and to pierce the p+/p- barrier by overlaying part (or the whole) of the n-junction with a nwell implant. The nwell implant is deep, and protrudes through the pwell into the lowly doped substrate. The eventual other nMOSFETs which are part of the active (or passive) pixel, are made with shallow junctions only, and do not protrude into the substrate. It is to be noted that if the complexity of the active pixel requires that it should contain pMOSFETS, thus to be processed in a nwell, then this nwell - being the same type of junction as in the light collecting junctions - will compete with the light collecting junction, and cancel its effect partly. This problem does not occur in active pixels that use only one type of MOSFET. In a custom process, this situation can be alleviated by having an even deeper p type implant for the nwell over the pMOSFETS, and not for the photo collection junctions.
- Junction spiking is known as an effect wherein the metallisation spikes through a shallow junction. This is one of the causes of high dark-current pixels. By putting the critical diode contact above a well, which is possible in the pixels of the present invention, the leakage to the substrate is avoided. This will yield an overall lower number of white pixels in a pixel matrix.

### Alternative embodiments of the present invention.

The photocollecting junction of a pixel in a CMOS based sensor, according to the invention, can be a depletion layer or an inversion layer of a MOS-structure or a buried channel MOSFET.

The photocollecting junction can also be a phototransistor, said phototransistor can be fabricated as a vertical pnp structure wherein the collector is the substrate, the base is the deep nwell implant, and the emitter is a p type region forming a shallow junction inside this well. Such a structure has similar charge collection properties as the preferred embodiment of the invention but it has the added value of internal current multiplication.

### pixel with integral memory element

The present invention can applied to make a pixels which have a memory element in the pixel, the memory element being better shielded from the light. An analog memory element is usually a capacitor, which has a part or parts which are junctions, or which has connections to other circuit elements such as transistors which have junctions. Junctions are light sensitive, and this light sensitivity will cause a current to flow which will affect the charge stored on the capacitor. A memory element or capacitor can be used for various purposes: spatial and temporal filtering, the memorisation of an image, etc. Figure 6 shows an example of a circuit where a frame that is acquired with a slow integration time, can be read out in a non-destructive way at high speed. In this figure, the light collection junction (1,4 -5, 6 can be reset by switch (e. g. a MOSFET) (20) . The signal being acquired in the light collection junction can be periodically sampled by switch (21) on capacitor (22). This voltage is then multiplexed in the classical ways over circuits represented as "A". The circuit of figure 6 should, in order to operate properly, have a stable signal on capacitor (22). Capacitor (22), and also the interconnections to it should be shielded from the light, which is straightforward by using metallisation. However, Capacitor (22), and/or the interconnections to it may also collect charge that is present in the substrate due to light generation. Especially photo charge that is being created deep in the substrate can diffuse easily onto Capacitor (22) or its interconnections, and discharge them. If the photo diode (1,4-5,6) is made according to the present invention, the charge diffusing in the substrate will likely be collected in the photodiode (1,4-5,6) and will thus not affect the charge on Capacitor (22).

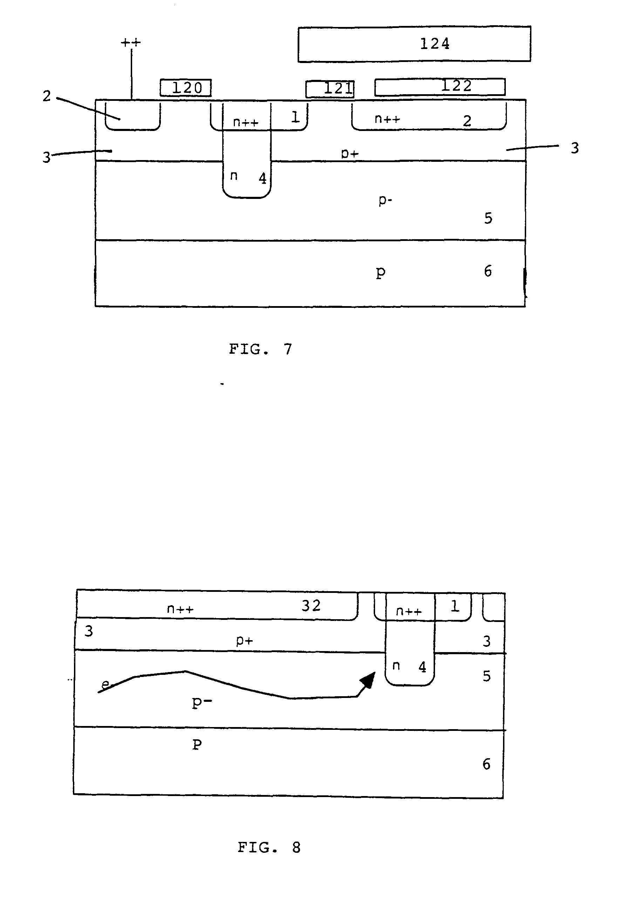

A cross section of a possible implementation is show in figure 7. Here the capacitor and switches are realised as MOS structures with a metal light shield (124) being deposited on the capacitor region, a dielectric being inbetween the metal shield (124) and the metal or polysilicon gate of the switches (121) (120) and of the capacitor (122); the amplification and multiplexing circuitry is not shown.

### The application of the well-pixel to obtain a pixel with low dark current

It is known in the art that the photodiode dark current is mainly due to thermal generation mechanisms at the edges of the diode, or at the interface between the Silicon and SiO₂. In CCD's the dark current can be significantly reduced by a method called "inversion mode" or "all phase pinning". In such a CCD, the Si-SiO₂ interface of the CCD is brought into inversion, so that the buried channel (the useful detecting volume) is not in contact any more with this interface. The methods reduces the dark current with a factor of typically 100.

The well-pixel of the present invention can be applied with the same goal. If the pixel is large compared to the light collection junction, the other area is to be covered with a structure that screens the bulk of the material from the surface. Two ways to do this are:
(a) using a screening junction (32) ;
(b) using an inversion layer (132), induced by a polysilicon gate electrode (37).

An example of (a) is shown in figure 8

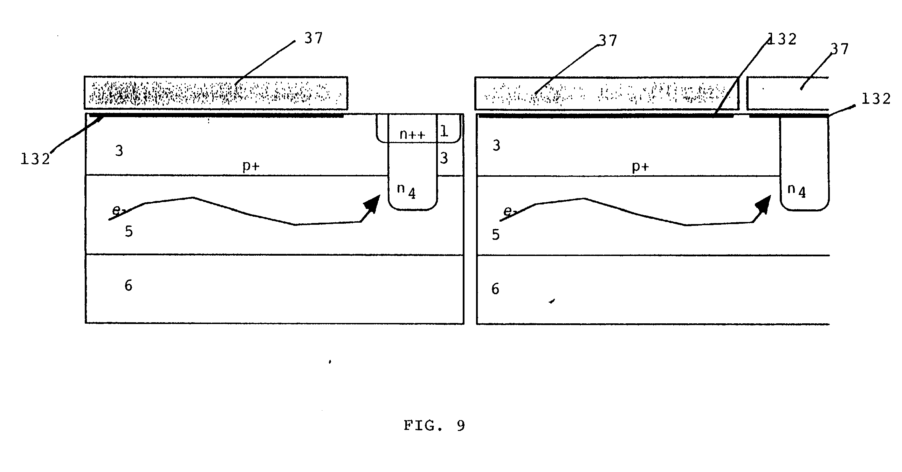

Two examples of (b), not forming part of the invention, are shown in figure 9 wherein is shown a polysilicon gate electrode (37) inducing a screening inversion layer (132) in the barrier region (3).

### On the implementation in a CCD or CCD-like structure

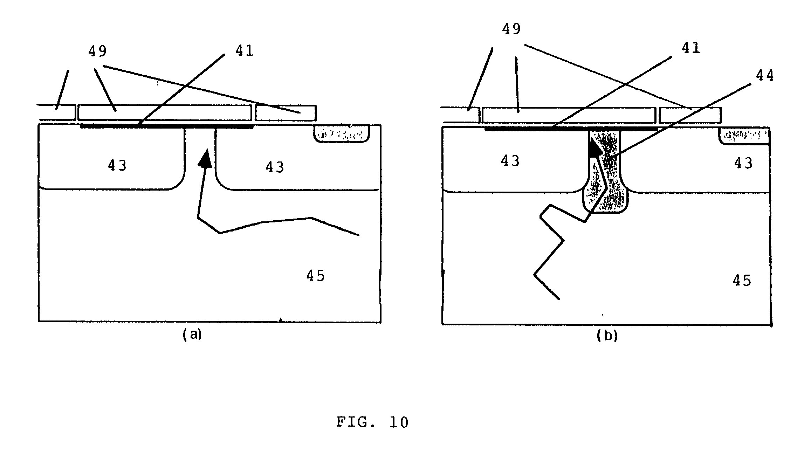

The invention is applicable to any active or passive pixel structure, and even to CCD-structures (see figure 10). The photocollection junction of the present invention can be a photo diode, but also a junction that consists essentially of a depletion layer or inversion layer (41) to the semiconductor substrate(45) (as in a surface channel CCD), or that consists essentially of a (partially) depleted buried channel to the semiconductor substrate or surface (as in a buried channel CCD). Such structures are typically used in CCDs, CIDs (charge injection devices), photo gates, or similar. These are called "virtual junctions", as they have in fact the same functionality as a physical n-p junction while collecting photo-generated charge carriers.

A CCD cell can thus be the light sensitive element itself, where the photo charge is collected in a potential pocket that is electrostatically induced by the CCD electrodes (49). If a potential barrier is present between the photosensitive volume (the substrate (47)) and the potential pocket, this will prevent the collection of charges. The present invention can thus be used to enhance the charge collection of the virtual junction. In figure 10 are shown two cross sections of surface channel CCD-like structures, where the barrier for electrons from the substrate to reach the inversion layer (41) of the CCD is suppressed: a) by an opening (omission) of the pwell (43) b) by an explicit n type implant (44) according to the principle of the invention that pierces or lowers said potential barrier.

## Claims

1. A detector of electromagnetic radiation, comprising:
a semiconductor substrate (6) of a first conductivity type P having a first dopant level p;
a first layer (5) of the first conductivity type P defined therein or thereon having a second dopant level p-;
a second layer (3) of the first conductivity type P, disposed upon the first layer (5) and having a third dopant level p+;
a first region (1) and a second region (2) of a second conductivity type N, disposed within the second layer (3) and having a fourth dopant level n++, wherein the second layer (3) comprises a third region separating the first region from the second region (2) and separating the first and second regions (1,2) from the first layer (5),
wherein the third region comprises a barrier to diffusion of charge carriers from the first layer (5) to the second region (2); and
a fourth region (4) of the second conductivity type N having a fifth dopant level n, the fourth region (4) extending from the first region (1) through the second layer (3) into the first layer (5).
wherein the first region (1) comprises a collection junction to collect the charge carriers,
wherein the second dopant level p- is less than the first dopant level p,
wherein the third dopant level p+ is greater than the first dopant level p and
wherein the fifth dopant level n is less than the fourth dopant level n++.

2. The detector as recited in claim 1, wherein the second region (2) and the second layer (3) comprise a junction adapted to process signals generated by the charge carriers collected by the collection junction.

3. The detector as recited in claim 1, wherein the fourth region (4) comprises a junction with the first layer, and wherein the junction comprises a photodiode.

4. The detector as recited in claim 1, further comprising a well of the first conductivity type in the first region (1), wherein the well comprises an emitter of a phototransistor, the first and fourth regions comprise a base of the phototransistor, and the semiconductor substrate comprises a collector of the phototransistor.

5. The detector as recited in claim 1, wherein the detector is integrated in a CCD or CCD-like sensor and wherein the first region comprises an inversion layer or a buried channel beneath an electrode of the CCD or CCD-like sensor.

6. The detector as recited in claim 5, wherein the CCD-like sensor is one of a photogate, a charge injection device and a charge sweep device.

7. The detector as recited in claim 1, wherein the third region provides an electrostatic barrier for impeding diffusion of charge carriers to the second region (2), the electrostatic barrier formed at an interface between the third region and the first layer (5).

8. The detector as recited in claim 7, wherein the second region and the second layer comprise a junction adapted to process signals generated by the charge carriers collected by the collection junction.

9. The detector as recited in claim 7, wherein the first region comprises a depletion layer or an inversion layer of an MOS component or of a buried channel MOS transistor.

10. The detector as recited in claim 7, further comprising a gate structure disposed upon the third region between the first region and the second region, wherein the first region, the second region, the third region and the gate structure constitute an MOS transistor.

11. The detector as recited in claim 10, further comprising an electromagnetic radiation shield (124) disposed over the gate structure and the second region, wherein the MOS transistor is configured as a switch to transfer accumulated charge from the first region to the second region, wherein the second region is operable as a memory element.

12. A method of manufacturing a CMOS-based pixel structure for detecting electromagnetic radiation, comprising:
defining a p- layer (5) in a p-type substrate (6);
defining a p+ layer (3) in or on the p- layer (5) to provide a diffusion barrier to photocharges generated in the p-type substrate (6) and the p- layer (5);
defining a first n++ (1) region and a second n++ region (2) within the p+ layer (3), wherein the first n++ region (1) is separated from the second n++ region (2) and the p- layer (5) by the p+ layer (3), and wherein the second n++ region (2) is separated from the first n++ region (1) and the p- layer by the p+ layer (3); and defining an n-type region (4) through the first n++ region (1) and the p+ layer (3) and into the p- layer (5) to collect in the first n++ region (1) the photocharges generated in the p-type substrate (6) and the p- layer (5).

13. The method as recited in claim 12, wherein the n-type region is one of an n-well implant, an anti-punch through implant, a blanket implant and a Vth-adjust implant.

## Patentansprüche

1. Ein Detektor elektromagnetischer Strahlung, der Folgendes beinhaltet:
ein Halbleitersubstrat (6) einer ersten P-Leitfähigkeit mit einem ersten Dotierungsniveau p;
eine darin oder darauf definierte erste Schicht (5) der ersten P-Leitfähigkeit mit einem zweiten Dotierungsniveau p-;
eine zweite Schicht (3) der ersten P-Leitfähigkeit, die auf der ersten Schicht (5) angeordnet ist und ein drittes Dotierungsniveau p+ aufweist;
einen ersten Bereich (1) und einen zweiten Bereich (2) einer zweiten N-Leitfähigkeit, die innerhalb der zweiten Schicht (3) angeordnet sind und ein viertes Dotierungsniveau n++ aufweisen, wobei die zweite Schicht (3) einen dritten Bereich aufweist, der den ersten Bereich von dem zweiten Bereich (2) trennt und den ersten und den zweiten Bereich (1, 2) von der ersten Schicht (5) trennt,
wobei der dritte Bereich eine Barriere für die Diffusion von Ladungsträgern von der ersten Schicht (5) in den zweiten Bereich (2) beinhaltet; und
einen vierten Bereich (4) der zweiten N-Leitfähigkeit mit einem fünften Dotierungsniveau n, wobei sich der vierte Bereich (4) von dem ersten Bereich (1) durch die zweite Schicht (3) in die erste Schicht (5) erstreckt,
wobei der erste Bereich (1) einen Sammelübergang zum Sammeln der Ladungsträger beinhaltet,
wobei das zweite Dotierungsniveau p- geringer als das erste Dotierungsniveau p ist,
wobei das dritte Dotierungsniveau p+ höher als das erste Dotierungsniveau p ist und
wobei das fünfte Dotierungsniveau n geringer als das vierte Dotierungsniveau n++ ist.

2. Detektor gemäß Anspruch 1, wobei der zweite Bereich (2) und die zweite Schicht (3) einen Übergang beinhalten, der angepasst ist, um Signale zu verarbeiten, die von den Ladungsträgern erzeugt werden, welche von dem Sammelübergang gesammelt werden.

3. Detektor gemäß Anspruch 1, wobei der vierte Bereich (4) einen Übergang zu der ersten Schicht beinhaltet und wobei der Übergang eine Photodiode beinhaltet.

4. Detektor gemäß Anspruch 1, der ferner in dem ersten Bereich (1) eine Wanne der ersten Leitfähigkeit beinhaltet, wobei die Wanne einen Emitter eines Phototransistors beinhaltet, der erste und der vierte Bereich eine Basis des Phototransistors beinhalten und das Halbleitersubstrat einen Kollektor des Phototransistors beinhaltet.

5. Detektor gemäß Anspruch 1, wobei der Detektor in einen CCD-Sensor oder CCD-ähnlichen Sensor integriert ist und wobei der erste Bereich eine Inversionsschicht oder einen vergrabenen Kanal unterhalb einer Elektrode des CCD-Sensors oder CCD-ähnlichen Sensors beinhaltet.

6. Detektor gemäß Anspruch 5, wobei der CCD-ähnliche Sensor einer von einem Photogate, einer Ladungsinjektionsvorrichtung und einer Sweep-out-Vorrichtung ist.

7. Detektor gemäß Anspruch 1, wobei der dritte Bereich eine elektrostatische Barriere zum Behindern der Diffusion der Ladungsträger in den zweiten Bereich (2) bereitstellt, wobei die elektrostatische Barriere an einer Grenzfläche zwischen dem dritten Bereich und der ersten Schicht (5) gebildet ist.

8. Detektor gemäß Anspruch 7, wobei der zweite Bereich und die zweite Schicht einen Übergang beinhalten, der angepasst ist, um Signale zu verarbeiten, die von den Ladungsträgern erzeugt werden, welche von dem Sammelübergang gesammelt werden.

9. Detektor gemäß Anspruch 7, wobei der erste Bereich eine Verarmungsschicht oder eine Inversionsschicht einer MOS-Komponente oder eines MOS-Transistors mit vergrabenem Kanal beinhaltet.

10. Detektor gemäß Anspruch 7, der ferner eine Gatestruktur, die auf dem dritten Bereich zwischen dem ersten Bereich und dem zweiten Bereich angeordnet ist, beinhaltet, wobei der erste Bereich, der zweite Bereich, der dritte Bereich und die Gatestruktur einen MOS-Transistor formen.

11. Detektor gemäß Anspruch 10, der ferner einen Schirm (124) gegen elektromagnetische Strahlung, welcher über der Gatestruktur und dem zweiten Bereich angeordnet ist, beinhaltet, wobei der MOS-Transistor als ein Schaltelement konfiguriert ist, um angesammelte Ladung von dem ersten Bereich in den zweiten Bereich zu transferieren, wobei der zweite Bereich als ein Speicherelement betriebsfähig ist.

12. Ein Verfahren zum Herstellen einer CMOS-basierten Pixelstruktur zum Erkennen von elektromagnetischer Strahlung, das Folgendes beinhaltet:
Definieren einer Schicht (5) des Typs p- in einem p-Substrat (6);
Definieren einer Schicht (3) des Typs p+ in oder auf der Schicht (5) des Typs p-, um eine Diffusionsbarriere für in dem p-Substrat (6) und in der Schicht (5) des Typs p- erzeugte Photoladungen bereitzustellen;
Definieren eines ersten Bereichs (1) des Typs n++ und eines zweiten Bereichs (2) des Typs n++ innerhalb der Schicht (3) des Typs p+, wobei der erste Bereich (1) des Typs n++ durch die Schicht (3) des Typs p+ von dem zweiten Bereich (2) des Typs n++ und der Schicht (5) des Typs p- getrennt ist und wobei der zweite Bereich (2) des Typs n++ durch die Schicht (3) des Typs p+ von dem ersten Bereich (1) des Typs n++ und der Schicht des Typs p- getrennt ist; und
Definieren eines n-Bereichs (4) durch den ersten Bereich (1) des Typs n++ und die Schicht (3) des Typs p+ und in die Schicht (5) des Typs p-, um in dem ersten Bereich (1) des Typs n++ die in dem p-Substrat (6) und der Schicht (5) des Typs p-erzeugten Photoladungen zu sammeln.

13. Verfahren gemäß Anspruch 12, wobei der n-Bereich einer von einer n-Wannen-Implantation, einer "Anti-punch-through-Implantation", einer "Blanket-Implantation" und einer Vth-Anpassungsimplantation ist.

## Revendications

1. Un détecteur de rayonnement électromagnétique, comprenant :
un substrat semi-conducteur (6) d'un premier type de conductivité P présentant un premier niveau de dopant p ;
une première couche (5) du premier type de conductivité P définie dans ou sur celui-ci présentant un deuxième niveau de dopant p- ;
une deuxième couche (3) du premier type de conductivité P, disposée sur la première couche (5) et présentant un troisième niveau de dopant p+ ;
une première région (1) et une deuxième région (2) d'un deuxième type de conductivité N, disposées à l'intérieur de la deuxième couche (3) et présentant un quatrième niveau de dopant n++, où la deuxième couche (3) comprend une troisième région séparant la première région de la deuxième région (2) et séparant la première et la deuxième régions (1, 2) de la première couche (5),
où la troisième région comprend une barrière à la diffusion de porteurs de charge de la première couche (5) à la deuxième région (2) ; et
une quatrième région (4) du deuxième type de conductivité N présentant un cinquième niveau de dopant n, la quatrième région (4) s'étendant de la première région (1) jusque dans la première couche (5) en passant par la deuxième couche (3),
où la première région (1) comprend une jonction de collecte pour collecter les porteurs de charge,
où le deuxième niveau de dopant p- est inférieur au premier niveau de dopant p,
où le troisième niveau de dopant p+ est supérieur au premier niveau de dopant p et
où le cinquième niveau de dopant n est inférieur au quatrième niveau de dopant n++.

2. Le détecteur tel qu'énoncé dans la revendication 1, où la deuxième région (2) et la deuxième couche (3) comprennent une jonction adaptée pour traiter des signaux générés par les porteurs de charge collectés par la jonction de collecte.

3. Le détecteur tel qu'énoncé dans la revendication 1, où la quatrième région (4) comprend une jonction avec la première couche, et où la jonction comprend une photodiode.

4. Le détecteur tel qu'énoncé dans la revendication 1, comprenant en outre un caisson du premier type de conductivité dans la première région (1), où le caisson comprend un émetteur d'un phototransistor, les première et quatrième régions comprennent une base du phototransistor, et le substrat semi-conducteur comprend un collecteur du phototransistor.

5. Le détecteur tel qu'énoncé dans la revendication 1, où le détecteur est intégré dans un CCD ou un capteur type CCD et où la première région comprend une couche d'inversion ou un canal enterré sous une électrode du CCD ou capteur type CCD.

6. Le détecteur tel qu'énoncé dans la revendication 5, où le capteur type CCD est ou bien un photogate, ou bien un dispositif à injection de charge, ou bien un dispositif à balayage de charge.

7. Le détecteur tel qu'énoncé dans la revendication 1, où la troisième région fournit une barrière électrostatique pour faire obstacle à la diffusion de porteurs de charge vers la deuxième région (2), la barrière électrostatique étant formée au niveau d'une interface entre la troisième région et la première couche (5).

8. Le détecteur tel qu'énoncé dans la revendication 7, où la deuxième région et la deuxième couche comprennent une jonction adaptée pour traiter des signaux générés par les porteurs de charge collectés par la jonction de collecte.

9. Le détecteur tel qu'énoncé dans la revendication 7, où la première région comprend une couche d'appauvrissement ou une couche d'inversion d'un composant MOS ou d'un transistor MOS à canal enterré.

10. Le détecteur tel qu'énoncé dans la revendication 7, comprenant en outre une structure à portillon disposée sur la troisième région entre la première région et la deuxième région, où la première région, la deuxième région, la troisième région et la structure à portillon constituent un transistor MOS.

11. Le détecteur tel qu'énoncé dans la revendication 10, comprenant en outre une protection contre le rayonnement électromagnétique (124) disposée par-dessus la structure à portillon et la deuxième région, où le transistor MOS est configuré tel un commutateur pour transférer la charge accumulée de la première région vers la deuxième région, où la deuxième région est exploitable comme unité de mémoire.

12. Une méthode de fabrication d'une structure pixel à base CMOS destinée à détecter un rayonnement électromagnétique, comprenant :
définir une couche p- (5) dans un substrat de type p (6) ;
définir une couche p+ (3) dans ou sur la couche p- (5) afin de fournir une barrière de diffusion aux photocharges générées dans le substrat de type p (6) et la couche p- (5) ;
définir une première région n++ (1) et une deuxième région n++ (2) à l'intérieur de la couche p+ (3), où la première région n++ (1) est séparée de la deuxième région n++ (2) et la couche p- (5) par la couche p+ (3), et où la deuxième région n++ (2) est séparée de la première région n++ (1) et la couche p- par la couche p+ (3) ; et
définir une région de type n (4) qui passe par la première région n++ (1) et la couche p+ (3) et va jusque dans la couche p- (5) afin de collecter dans la première région n++ (1) les photocharges générées dans le substrat de type p (6) et la couche p- (5).

13. La méthode telle qu'énoncée dans la revendication 12, où la région de type n est ou bien un implant à caisson n (n-well implant), ou bien un implant anti-perçage (anti-punch through implant), ou bien un implant de couverture (blanket implant), ou bien un implant à ajustement de Vth (Vth-adjust implant).
